# EUROPEAN PATENT APPLICATION

(11) **EP 2 816 620 A1**
(43) Date of publication of application: **24.12.2014**
(21) Application number: 13749248.4
(22) Date of filing: 04.02.2013
(51) Int. Cl.: H01L 33/50, H01L 23/28, H01L 33/52

(54) **WAVELENGTH CONVERSION ELEMENT AND METHOD FOR MANUFACTURING SAME, AND LIGHT-EMITTING DEVICE AND METHOD FOR MANUFACTURING SAME**

(30) Priority: 13.02.2012 JP 2012028496
(71) Applicant: Konica Minolta, Inc., Tokyo 100-7015 (JP)
(72) Inventor: GOTO Kenji, Hino-Shi Tokyo 191-8511 (JP)
(74) Representative: Henkel, Breuer & Partner
(86) International application number: PCT/JP2013/052433
(87) International publication number: WO 2013/121903

(57) **Abstract**

A light-emitting device for lighting or other applications where uniformity of color is sought, wherein, in order to reduce the incidence of color variation to an adequately usable degree, and improve the prevention of sulfuration and light-extraction efficiency, the light-emitting device is manufactured using a method having: a step for applying to a light-emitting element a fluorescent substance, swellable particles, inorganic particles, and a first mixture containing a first solvent; a subsequent step for applying and heating a translucent ceramic material and a second mixture containing a second solvent; and a subsequent step for applying and heating a silicone sealant.

## Description

### Technical Field

The present invention relates to a light emitting device that has a light emitting element and a wavelength conversion portion that converts a wavelength of light emitted from the light emitting element.

### Background Art

In recent years, a technology is widely used to obtain a light emitting device for emitting white light, in which a fluorescer such as a YAG (yttrium·aluminun·garnet) fluorescer or the like is disposed in the vicinity of a gallium nitride (GaN) blue LED (Light Emitting Diode) chip; blue light emitted from the blue LED chip and yellow light emitted from the fluorescer that receives the blue light to perform secondary light emission are mixed with each other to produce white light. Besides, also a technology is used to obtain a light emitting device for emitting white light, in which blue light emitted from a blue LED chip, red light and green light emitted from respective fluorescers that receive the blue light to perform secondary light emission are mixed with one another to produce white light.

Such white light emitting devices have various uses and are used as an alternative for a fluorescent lamp and an incandescent lamp, for example. Besides, white light emitting devices are being used in illumination devices such as a headlight for a car and the like that are required to have very high brightness. A headlight is required to allow targets such as a distant sign and the like to be highly visible; accordingly, as a white light emitting device, is required to have high performance in terms of tint and color evenness in an illumination range.

In such white light emitting devices, a method is general, in which a transparent resin in which fluorescers are dispersed is used to seal an LED chip and a mounting portion. However, in the use that requires the above high-level color evenness, specific gravity of the fluorescer particles is larger than the transparent resin in the structure in which the fluorescers are simply dispersed in the transparent resin to seal the LED chip; accordingly, there is a problem that the fluorescers precipitate before the transparent resin cures and color unevenness and the like occur during a light emitting time. And, also there is a problem that a metal electrode and a metal reflection portion are sulfurized depending on a use environment, whereby light emission efficiency declines.

Accordingly, various technologies are proposed, which curb the precipitation of a fluorescer to prevent the occurrence of color unevenness and the like. For example, a patent document 1 discloses a light emitting device that uses a silicone resin, which has a viscosity of 100 to 10000 mPa·s during a time the resin hardens, as a sealant to curb the precipitation and segregation of a fluorescer.

Besides, a patent document 2 discloses a light emitting device and method for producing the same in which a lipophilic compound, which is obtained by adding an organic cation to a layered compound that contains chiefly a clay mineral, is added as a material that prevents a fluorescer from precipitating.

A patent document 3 discloses a structure in which a barrier layer for sulfurization prevention is disposed.

### Citation List

### Patent Literature

PLT1: JP-A-2002-314142
PLT2: JP-A-2004-153109
PLT3: JP-A-2011-96842

### Summary of Invention

### Technical Problem

According to the technologies in the patent documents 1, 2, the problem of color unevenness due to the precipitation of a fluorescer is somewhat improved. However, in all the documents, the fluorescers are dispersed in a resin; accordingly, in a case of using the technologies for the above high-brightness illumination device, problems are likely to occur, in which because of heat generation from the LED itself and heat due to the light emission from the fluorescer excited by the light from the LED, the resin deteriorates to be colored, whereby the transmittance declines, and color unevenness and surface scattering due to deformation of the resin occur. Besides, even if the high-brightness LED is not used, the same problems are likely to occur after a long-time use. Besides, the technology in the patent document 3 is not sufficient as a sulfurization preventing measure.

The present invention has issues of reducing occurrence of color unevenness to the extent where a light emitting device is sufficiently usable in a use such as illumination and the like that require color evenness and improving sulfurization prevention performance and light output efficiency, and it is an object of the present invention to provide a wavelength conversion element, a method for producing the wavelength conversion element, a light emitting device, and a method for producing the light emitting device.

### Solution to Problem

To achieve the above object, the present invention is a method for producing a light emitting device that comprises: a step for applying a first mixed liquid, which contains a fluorescer, swelling particles, inorganic particles, and a first solvent, onto a light emitting element, a step for applying a second mixed liquid, which contains a light-transmissive ceramic material and a second solvent, onto the first mixed liquid and heating the second mixed liquid, and further a step for applying a silicone sealing material onto the second mixed liquid and heating the silicone sealing material.

In the above method for producing a light emitting device, it is preferable that the second mixed liquid contains water and/or inorganic particles.

Besides, in the above method for producing a light emitting device, it is preferable that the inorganic particles are a metal oxide.

Besides, in the above method for producing a light emitting device, it is preferable that the silicone sealing material is phenyl silicone.

Besides, a light emitting device according to the present invention is produced by any one of the methods for producing a light emitting device.

Besides, the present invention is a method for producing a wavelength conversion element that comprises: a step for applying a first mixed liquid, which contains a fluorescer, swelling particles, inorganic particles, and a first solvent, onto at last one surface of a light-transmissive substrate, a step for applying a second mixed liquid, which contains a light-transmissive ceramic material and a second solvent, onto the first mixed liquid and heating the second mixed liquid, and further a step for applying a silicone sealing material onto the second mixed liquid and heating the silicone sealing material.

In the above method for producing a wavelength conversion element, it is preferable that the second mixed liquid contains water and/or inorganic particles.

Besides, in the above method for producing a wavelength conversion element, it is preferable that the inorganic particles are a metal oxide.

Besides, in the above method for producing a wavelength conversion element, it is preferable that the silicone sealing material is phenyl silicone.

Besides, a wavelength conversion element according to the present invention is produced by the above method for producing a wavelength conversion element.

Besides, a method for producing a wavelength conversion element according to the present invention comprises a step for disposing the wavelength conversion element onto a light emitting side of a light emitting element, the step being added to the method for producing a wavelength conversion element.

Besides, a light emitting device according to the present invention is produced by the above method for producing a light emitting device.

### Advantageous Effects of Invention

According to the present invention, it is possible to reduce occurrence of the color unevenness to the extent where the light emitting device is sufficiently usable in usees such as illumination and the like that require the color evenness and improving the sulfurization prevention performance and light output efficiency.

### Brief Description of Drawings

[Fig. 1] is a schematic cross-sectional view of a light emitting device according to a first embodiment of the present invention.
[Fig. 2] is a schematic view for schematically describing an applying device and a producing method that use a spray coating method.
[Fig. 3] is a schematic cross-sectional view of a light emitting device according to a second embodiment of the present invention.
[Fig. 4] is a schematic cross-sectional view of a light emitting device according to a third embodiment of the present invention.
[Fig. 5] is a view showing results of evaluation of light emission efficiency, evaluation of tolerance to sulfurization, and evaluation of chromaticity in an example and a comparative example.

### Description of Embodiments

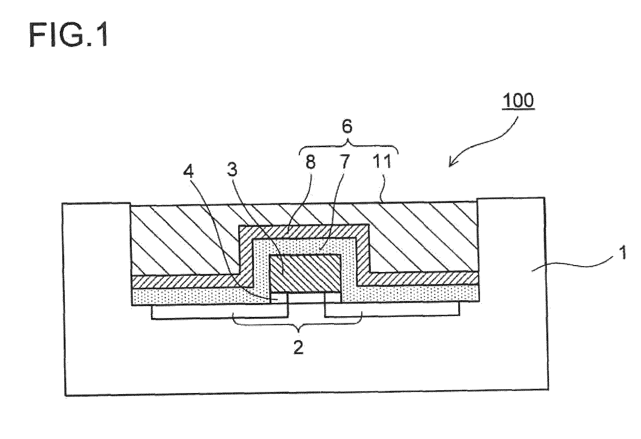

Hereinafter, embodiments of a wavelength conversion element according to the present invention and a light emitting device that includes the wavelength conversion element are described with reference to the drawings. Fig. 1 is a schematic cross-sectional view of a light emitting device according to a first embodiment of the present invention. As shown in Fig. 1, a light emitting device 100 is provided with a metal portion 2 on a bottom portion of an LED board 1 that has a concave shape in cross section, and an LED element 3 as a light emitting element is disposed on the metal portion 2. The LED element 3 is provided with a protrusive electrode 4 on a surface that opposes the metal portion 2, and the metal portion 2 and the LED element 3 are connected to each other via the protrusive electrode 4 (flip chip type).

In the present embodiment, a blue LED element is used as the LED element 3. The blue LED element is formed by laminating, on a sapphire substrate, for example, an n-GaN clad layer, an InGaN light emitting layer, a p-GaN clad layer, and a transparent electrode.

Besides, a wavelength conversion portion 6 is disposed in a concave portion of the LED board 1 to cover the LED element 3. The wavelength conversion portion 6 has: a wavelength conversion layer 7 that covers the LED element 3; a ceramic layer 8 formed on the wavelength conversion layer 7; and a silicone sealing layer 11 formed on the ceramic layer 8.

The wavelength conversion layer 7 is a portion that converts light of a predetermined wavelength emitted from the LED element 3 into light of a different wavelength, and includes a fluorescer that is excited by the wavelength from the LED element 3 to emit fluorescent light of a wavelength different from the excitation wavelength. The ceramic layer 8 is a layer that seals and protects the wavelength conversion layer 7, and has light transmissiveness that transmits at least the light front the LED element 3 and the fluorescent light from the wavelength conversion layer 7. The silicone sealing layer 11 is a layer aiming at improvement in gas barrier characteristic, physical strength, light output efficiency and the like, and has light transmissiveness that transmits at least the light from the LED element 3 and the fluorescent light from the wavelength conversion layer 7.

Next, a structure and forming method of the wavelength conversion portion 6 (wavelength conversion layer 7, ceramic layer 8, and silicone sealing layer 11) and a producing method of the light emitting device 100 are described in detail.

The wavelength conversion layer 7 is a layer that is obtained by applying a mixed liquid (first mixed liquid) that contains at least fluorescers, swelling particles, inorganic particles (inorganic micro-particles), and a solvent (first solvent) and heating (drying) it. Here, if the first mixed liquid contains a light-transmissive ceramic material that serves as a binder, as time passes after preparation, the ceramic material takes chemical reaction to rise in viscosity to the extent where it is not preferable to apply the mixed liquid in 168 hours after the preparation. In other words, if the first mixed liquid contains a binder component, the pot life of the first mixed liquid becomes short. Accordingly, it is preferable that the first mixed liquid contains less binder component and more preferable that the first mixed liquid contains no binder component.

The ceramic layer 8 is a transparent ceramic layer (glass body) that is obtained by applying a mixed liquid (second mixed liquid) that contains at least a light-transmissive material and a solvent (second solvent) and heating (calcining) it. In the meantime, the second mixed liquid may contain swelling particles, water, inorganic particles and the like. The silicone sealing layer 11 is a layer that is obtained by applying a silicone sealing material that contains a silicone resin and heating (hardening) it.

### (Fluorescer)

The fluorescer is excited by the wavelength (excitation wavelength) of the light emitted from the LED element 3 to emit fluorescent light of a wavelength different from the excitation wavelength. The present embodiment uses a YAG (yttrium·aluminum·garnet) fluorescer that converts blue light (wavelengths of 420 nm to 485 nm) emitted from the blue LED element into yellow light (wavelengths of 550 nm to 650 nm).

As to such fluorescer, oxides of Y, Gd, Ce, Sm, Al, La, Ga, or compounds that easily become oxides at a high temperature are used, and they are mixed sufficiently at a stoichiometric ratio to obtain a mixed raw material. Or, rare earth elements of Y, Gd, Ce, Sm are dissolved in acid at a a stoichiometric ratio to obtain a solution. The solution is co-precipitated with oxalic acid and calcined to obtain a co-precipitated oxide. The co-precipitated oxide, aluminum oxide, and gallium oxide are mixed to obtain a mixed raw material. And, a suitable amount of fluoride such as ammonium fluoride or the like is added as flux to the obtained mixed raw material and pressurized to obtain a component body. The obtained component body is put into a crucible and calcined in the air in a temperature range of 1350 to 1450°C for 2 to 5 hours to obtain a sintered body that has a light emission characteristic of a fluorescer.

In the meantime, the present embodiment uses the YAG fluorescer; however, the kind of the fluorescer is not limited to this, and for example, it is also possible to use another fluorescer such as a non-garnet fluorescer or the like that does not contain Ce, for example. Besides, the larger the particle diameter of the fluorescer is, the higher the light emission efficiency (wavelength conversion efficiency) becomes, on the other hand, the gap appearing in an interface between the fluorescer and the swelling particles becomes large, so that film strength of the formed wavelength conversion layer 7 declines. Accordingly, it is preferable to use fluorescers that have a volume average particle diameter of 1 µm or larger to 50 µm or smaller considering the light emission efficiency and the size of the gap that appears in the interface between the fluorescers and the swelling particles. It is possible to measure the volume average particle diameter of the fluorescers by means of a Coulter-counter method or a laser diffraction/scattering particle diameter measuring apparatus, for example.

### (Swelling particle)

As the swelling particles, it is possible to use fluoride particles of magnesium fluoride, aluminum fluoride, calcium fluoride or the like, a layered silicate mineral, imogolite, allophane or the like. As the layered silicate mineral, a swelling clay mineral, which has a mica structure, a kaolinite structure, a smectite structure or the like, is more preferable. The layered silicate mineral has a card-house structure in the mixed liquid; accordingly, there is an effect of dramatically increasing the viscosity of a mixed liquid by means of a small amount. Besides, the layered silicate mineral has a flat-plate shape; accordingly, there is also an effect of improving the film strength of the wavelength conversion layer 7.

The mineral here is a solid substance that is natural or synthetic, inorganic and has a specific chemical composition and a crystal structure. As such layered silicate mineral, there are natural or synthetic smectite group clay minerals such as hectorite, saponite, stevensite, beidellite, montmorillonite, nontronite, bentonite and the like, swelling mica group clay minerals such as Na-tetrasilicic fluoromica, Li- tetrasilicic fluoromica, Na-fluoro taeniolite, Li- fluoro taeniolite, and the like, vermiculite, kaolinite, or a mixture of vermiculite and kaolinite.

Besides, if the content of the swelling particles in the first mixed liquid becomes lower than 0.1 weight%, the percentage of solid components such as the fluorescer, micro-particles, metal alkoxide in the first mixed liquid rises, so that the dispersion of them deteriorates. On the other hand, if the content of the swelling particles exceeds 60 weight%, much scattering of the excitation light caused by the swelling particles occur, so that light emission brightness declines in the wavelength conversion layer 7 and light transmissiveness declines in the ceramic layer 8. Accordingly, it is preferable that the content of the swelling particles is 0.1 weight% or more to 60 weight% or less, and more preferable that the content of the swelling particles is 0.5 weight% or more to 30 weight% or less.

The swelling particles have a thickening effect; however, even if the percentage of the swelling particles is high in the wavelength conversion layer 7 and the ceramic layer 8, it does not always mean that the viscosity of the mixed liquid becomes high, but the viscosity of the mixed liquid is decided by the ratio of the swelling particles to the other components such as the solvent, the fluorescer and the like. In the meantime, it is also possible to suitably use swelling particles whose surfaces are modified (surface-treated) by means of ammonium salts and the like considering compatibility with the solvent.

### (Solvent)

As the solvent, it is possible to use water, organic solvent, or mixed solvent of water and organic solvent. Water plays a role in swelling hydrophilic swelling particles. For example, adding water to fluoride particles increases the viscosity of the mixed liquid; accordingly, it is possible to curb the precipitation of the fluorescer. In the meantime, there is a risk that impurities contained in water would discourage the swelling; accordingly, as the added water, it is necessary to use pure water that contains no impurities.

The organic solvent is used to improve wettability of the mixed liquid and adjust the viscosity. For example, adding the organic solvent to fluoride particles increases the viscosity of the mixed liquid; accordingly, it is possible to curb the precipitation of the fluorescer. In a case where water is added to hydrophilic swelling particles to swell the swelling particles, it is preferable to use, as the organic solvent, alcohol such as methanol, ethanol, propanol, butanol or the like that is excellent in compatibility with water. In the meantime, a combination of two or more kinds of alcohol may be used. On the other hand, in a case where lipophilic swelling particles are used, water does not work on the swelling of the swelling particles. However, adding water increases the viscosity; accordingly, it is preferable to use organic solvent that is excellent in compatibility with water. Besides, by using organic solvent such as ethylene glycol, propylene glycol or the like that has a high boiling point, the pot life of the mixed liquid does not becomes short, nozzle clogging is prevented during a spray applying time, and handling is excellent.

### (Inorganic particle)

The inorganic particles have a filling effect of filling the gap that occurs in the interface between the fluorescer and the swelling particles and a thickening effect of increasing the viscosity of the mixed liquid before heating. As the inorganic particles used in the present invention, there are metal oxide micro-particles of silicon oxide, titanium oxide, zinc oxide, aluminum oxide, zirconium oxide and the like. In the meantime, it is also possible to suitably use inorganic particles whose surfaces are processed by means of a silane coupling agent or a titanate coupling agent considering compatibility with the ceramic material and the solvent.

Besides, if the content of the inorganic particles in the wavelength conversion layer 7 becomes lower than 0.5 weight%, the percentage of solid components such as the fluorescer and the like in the first mixed liquid rises, so that the dispersion of them deteriorates, handling during an applying time deteriorates, and it becomes hard to perform the applying at a constant chromaticity. On the other hand, if the content of the inorganic particles exceeds 70 weight%, much scattering of the excitation light caused by the inorganic particles occur, so that the light emission brightness declines in the wavelength conversion layer 7. Accordingly, it is preferable that the content of the inorganic particles in the first mixed liquid is 0.5 weight% or more to 70 weight% or less, and more preferable that the content of the inorganic particles is 0.5 weight% or more to 65 weight% or less.

The inorganic particles have a thickening effect; however, even if the percentage of the inorganic particles is high in the wavelength conversion layer 7, it does not always mean that the viscosity of the mixed liquid becomes high, but the viscosity of the mixed liquid is decided by the ratio of the inorganic particles to the other elements such as the solvent, the fluorescer and the like.

The inorganic particles are not especially limited in particle diameter distribution, namely, may disperse in a relatively wide range or may disperse in a relatively narrow range. In the meantime, as to the particle diameter of the inorganic particles, it is preferable that a central particle diameter of primary particles is 0.001 µm or more to 50 µm or less that is smaller than the fluorescer. It is possible to measure an average particle diameter of the inorganic particles by means of the Coulter-counter method, for example.

### (Light-transmissive ceramic material)

The light-transmissive ceramic material is a ceramic precursor, and an inorganic or organic metal compound is usable. As the metal compound, there are metal alkoxide, metal acetylacetonate, metal carboxylate, metal nitrate, metal oxide and the like; however, the metal alkoxide, which easily gels through hydrolysis and polymerization reaction, is preferable.

The metal alkoxide may be monomolecular such as tetraethoxysilane, or may be polysiloxane in which an organic siloxane compound forms a chain shape or a ring shape; however, the polysiloxane, which increases the viscosity of the mixed liquid, is preferable. In the meantime, if a light-transmissive glass body can be formed, the kind of the metal is not limited; however, it is preferable that silicon is contained from the viewpoint of stability and easy production of the formed glass body. Besides, a plurality of kinds of metals may be contained.

### (Silicone sealing material)

As the silicone sealing material, it is possible to use a resin that has, as a skeleton, a structure in which silicon atoms, which have an organic group such as an alkyl group, an aryl group or the like, are bonded alternately to oxygen atoms. In the meantime, another additive element may be given to the skeleton. For example, by applying phenyl silicone as the silicone sealing material onto the ceramic layer 8 and heating it at 150°C for 1 hour, it is possible to form the silicone sealing layer 11.

### (Preparation procedure of the first mixed liquid)

As a preparation procedure of the first mixed liquid, the fluorescer, the swelling particles, the inorganic particles (inorganic micro-particles), the solvent (first solvent) are simply mixed. The preferred viscosity of the first mixed liquid is 10 to 1000 mPa·s, the more preferred viscosity is 12 to 800 mPa·s, and the most preferred viscosity is 20 to 600 mPa·s.

### (Preparation procedure of the second mixed liquid)

As a preparation procedure of the second mixed liquid, when necessary, the swelling particles, the water, and the inorganic particles are mixed with the solution that is obtained by dispersing the light-transmissive ceramic material into the solvent (second solvent). By adding the swelling particles to the second mixed liquid, the light-transmissive ceramic layer, which is unlikely to crack even if applied thick, is formed.

When using the second mixed liquid, the transparent ceramic layer may be formed by means of a so-called sol-gel method in which a sol-like precursor solution is heated into a gel state, further calcined, or the transparent ceramic layer may be formed directly without being calcined to be gelatinized. In the case where the sol·gel method is used, it is preferable to suitably mix, for example, metal alkoxide, water for hydrolysis, solvent, a catalyst and the like. As the catalyst, it is possible to use hydrochloric acid, sulfuric acid, nitric acid, acetic acid, hydrofluoric acid, ammonia or the like. In a case where tetraethoxysilane isd used as the metal alkoxide, it is preferable to use 138 mass parts of ethyl alcohol, 52 mass parts of pure water for 100 mass parts of tetraethoxysilane. In this case, temperatures of 120 to 250°C for heating the gel are preferable, and 120 to 200°C are preferable from a viewpoint of more curbing deterioration of the LED element 3. Besides, in a case where polysiloxane is used as the metal alkoxide, heating temperatures of 120 to 500°C after the application are preferable, and 120 to 350°C are preferable from a viewpoint of more curbing the deterioration of the LED element 3.

### (Method for producing the light emitting device)

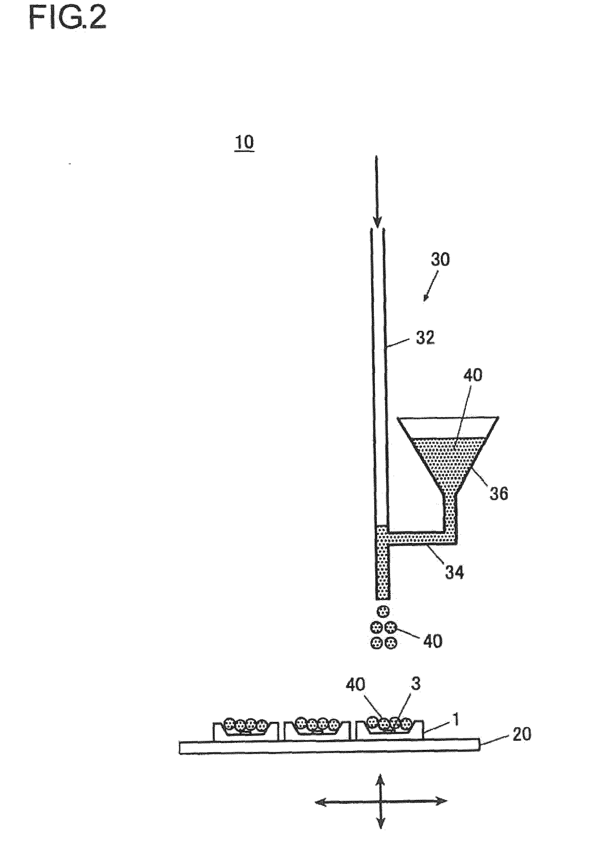

The first mixed liquid obtained as described above is sprayed, by means of the spray coating method, by a predetermined amount onto the LED board 1 on which the LED element 3 is mounted. Fig. 2 shows a schematic view for schematically describing an applying device and a producing method that use the spray coating method. An applying device 10 has mainly a moving table 20 that is movable vertically, horizontally, back and forth and a spray device 30 that is able to spray the first mixed liquid.

The spray device 30 is disposed above the moving table 20. The spray device 30 has a nozzle 32 into which air is sent, and the nozzle 32 is connected to an air compressor (not shown) for sending air. A tip end portion of the nozzle 32 has a hole diameter of 20 µm to 2 mm, preferably 0.1 to 0.3 mm. Like the moving table 20, the nozzle 32 is movable vertically, horizontally, back and forth.

For example, the spray gun W-101-142BPG from ANEST IWATA CORPORATION is used as the nozzle 32 and the 0FP-071C from ANEST IWATA CORPORATION is used as the compressor. The nozzle 32 can be angle-adjusted and inclined with respect to the moving table 20 (or to the LED board 1 disposed on the moving table). It is preferable that the angle of the nozzle 32 to a spray target (LED board 1) is in a range 0 to 60° when a direction perpendicular to the spray target is defined 0°.

The nozzle 32 is connected to a tank 36 via a connection tube 34. The first mixed liquid 40 is stored in the tank 36. A stirrer is disposed in the tank 36 and the first mixed liquid 40 is always stirred. If the first mixed liquid 40 is stirred, it is possible to prevent the precipitation of the fluorescer that has a large specific gravity, and keep the state where the fluorescer is dispersed in the first mixed liquid 40. For example, as the tank, the PC-51 from ANEST IWATA CORPORATION is used.

In the case where the first mixed liquid 40 is actually applied, a plurality of the LED boards 1 (on which the LED element 3 is mounted beforehand) are put on the moving table 20, and a positional relationship among the LED board 1, spray device 30, and nozzle 32 is adjusted (position adjusting step).

In detail, the LED board 1 is put on the moving table 20, and the LED board 1 and the tip end portion of the nozzle 32 are disposed to oppose each other. As a distance between the LED board 1 and the nozzle 32 becomes longer, it is possible to apply the first mixed liquid 40 more evenly, but the film strength tends to decline; accordingly, it is suitable to keep the distance between the LED board 1 and the tip end portion of the nozzle 32 in a range of 3 to 30 cm.

Thereafter, with the LED board 1 and the nozzle 32 being moved relatively, the first mixed liquid 40 is sprayed from the nozzle 32 and applied onto the LED board 1 (spraying-applying step). In detail, on the other hand, the moving table 20 and the nozzle 32 are moved to move the LED board 1 and the nozzle 32 horizontally, back and forth. A position of either one of the moving table 20 and the nozzle 30 may be fixed while the other may be moved horizontally, back and forth. Besides, an applying method is preferably used, in which a plurality of the LED elements 3 are disposed in a direction perpendicular to the moving direction of the moving table 20 and the applying is performed with the nozzle 32 being moved in the direction perpendicular to the moving direction of the moving table 20.

On the other hand, air is sent into the nozzle 32 to spray the first mixed liquid 40 from the tip end portion of the nozzle 32 onto the LED board 1. The distance between the LED board 1 and the nozzle 32 is adjustable in the above range considering a pressure of the air compressor. For example, the pressure of the compressor is adjusted such that a pressure of an inlet portion (tip end portion) of the nozzle 32 becomes 0.14 MPa. Thanks to the above operation, it is possible to apply the first mixed liquid 40 onto the LED element 3.

In the meantime, instead of using the applying device 10, a dispenser or an ink jet device may be used to apply (drop or spew) the first and second mixed liquids and the silicone sealing material. In a case where a dispenser is used, a nozzle, which allows an amount of the applied liquid dropped to be controlled and prevents the nozzle from clogging with the fluorescer, is used. For example, it is possible to use a non-contact jet dispenser from Musashi Engineering, Inc. and a dispenser from this company. Also in a case where an ink jet device is used, a nozzle, which allows an amount of the applied liquid spewed to be controlled and prevents the nozzle from clogging with the fluorescer, is used. For example, it is possible to use an ink jet device from Konicaminolta IJ Technologies, Inc.

By heating (drying) the first mixed liquid that is applied as described above, the wavelength conversion layer 7 having a constant thickness (constant fluorescer distribution) is formed on the LED element 3. Next, the second mixed liquid is sprayed by a predetermined amount onto the wavelength conversion layer 7 by means of the spray coating method. Here also, it is possible to use the applying device 10. Part of the second mixed liquid applied infiltrates into gaps among the fluorescer particles and the swelling particles. By heating (calcining) this, the ceramic layer 8 is formed.

Here, the second mixed liquid infiltrating into the wavelength conversion layer 7 changes to a ceramic; accordingly, the ceramic works, as a binder, on the fluorescer particles, the swelling particles and the LED element 3. Besides, the second mixed liquid has a suitable viscosity; accordingly, the ceramic layer 8 is surely formed on the wavelength conversion layer 7, and the second mixed liquid has also a function to seal the wavelength conversion layer 7.

In the meantime, in a case where the thickness of the wavelength conversion layer 7 formed is smaller than 5 µm, the wavelength conversion efficiency declines and sufficient fluorescent light is not obtained, and in a case where the thickness of the wavelength conversion layer 7 formed is larger than 500 µm, the film strength declines, and a crack and the like become likely to occur. Accordingly, it is preferable that the thickness of the wavelength conversion layer 7 is 5 µm or larger to 500 µm or smaller.

Next, the silicone sealing material is applied by a predetermine amount onto the ceramic layer 8 by means of a dispenser. By heating (hardening) this, the silicone sealing layer 11 is formed.

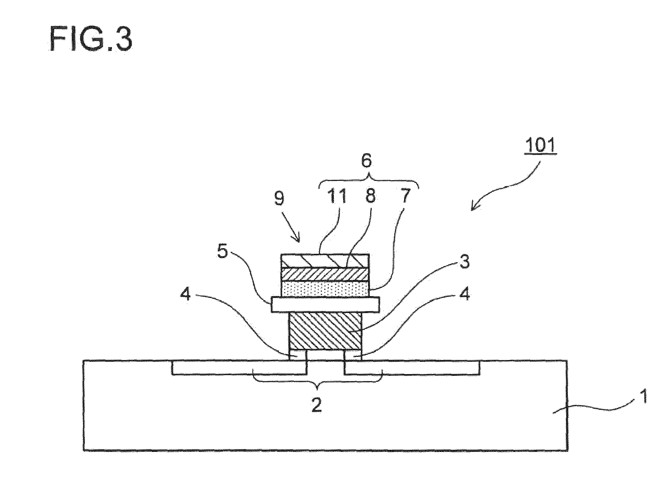

Fig. 3 is a schematic cross-sectional view of a light emitting device according to a second embodiment of the present invention. As shown in Fig. 3, in a light emitting device 101, the metal portion 2 is disposed on the flat-plate-shaped LED board 1, and the LED element 3 is disposed as the light emitting element on the metal portion 2. The LED element 3 is provided with the protrusive electrode 4 on a surface that opposes the metal portion 2, and the metal portion 2 and the LED element 3 are connected to each other via the protrusive electrode 4 (flip chip type).

Besides, the LED element 3 is provided, on an upper surface thereof, with a wavelength conversion element 9. The wavelength conversion element 9 has a glass substrate 5 and the wavelength conversion portion 6 formed on an upper surface of the glass substrate 5. The shape of the glass substrate 5 is not especially limited: it is possible to use a flat-plat shape, a lens shape and the like. In the meantime, the wavelength conversion portion 6 may be formed on a lower surface of the glass substrate 5. The wavelength conversion portion 6 has: the wavelength conversion layer 7 formed on the glass substrate 5; the ceramic layer 8 formed on the wavelength conversion layer 7; and the silicone sealing layer 11 formed on the ceramic layer 8.

As a method for producing the light emitting device 101, the first mixed liquid is applied by a predetermined amount onto one surface of the glass substrate 5 and heated to form the wave length conversion layer 7 that has a predetermined thickness. Next, the second mixed liquid is applied by a predetermined amount onto an upper surface of the wavelength conversion layer 7. Part of the second mixed liquid applied infiltrates into gaps among the fluorescer particles and the swelling particles. By calcining the glass substrate 5 on which the second mixed liquid is applied, the ceramic layer 8 is formed. Next, the silicone sealing material is applied by a predetermine amount onto the ceramic layer 8. By heating the glass substrate 5 on which the silicone sealing material is applied, the silicone sealing layer 11 is formed.

In the meantime, the applying methods of the first and second mixed liquids and the silicone sealing material are not especially limited: it is possible to use various methods conventionally known such as a bar coating method, a spin coating method, a spray coating method and the like.

And, the glass substrate 5, on which the wavelength conversion portion 6 is formed, is cut into a predetermined size (e.g., 2×2 mm) and disposed onto the LED element 3, whereby it is possible to produce the light emitting device 100.

In the meantime, in the above embodiment, the glass substrate 5 is used; however, the glass substrate is not limiting, but a substrate formed of a light-transmissive inorganic material, for example, a crystal substrate formed of single-crystal sapphire or the like, or a ceramic substrate may be used.

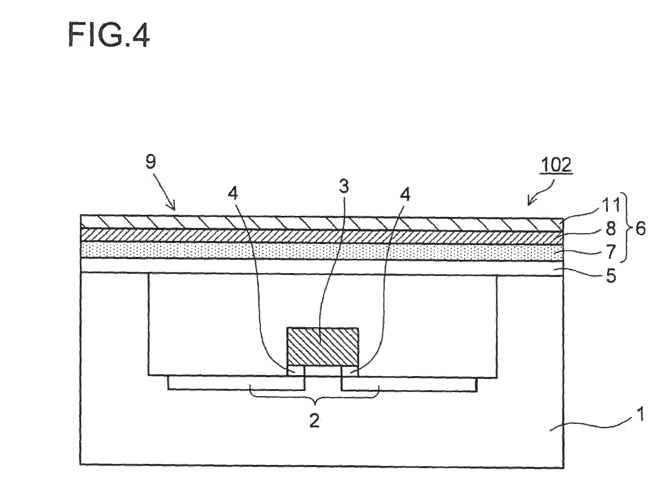

Fig. 4 is a schematic cross-sectional view of a light emitting device according to a third embodiment of the present invention. A light emitting device 102 is provided with the metal portion 2 on a bottom portion of the LED board I that has a concave shape in cross section, the LED clement 3 is disposed on the metal portion 2, and the wavelength conversion element 9 is disposed to cover the concave portion of the LED element 1. The structures of the other portions including the wavelength conversion element 9 are the same as the second embodiment; accordingly, description of them is skipped.

It is possible to produce the light emitting device 102 according to the present embodiment by disposing the LED element 3 into the concave portion of the LED board 1 and bonding the wavelength conversion element 9, which is used in the second embodiment, to an upper end of a side wall of the LED board 1 to cover the concave portion.

Compared to the second embodiment, the light emitting device 102 according to the present embodiment, light emitted from a side surface of the LED element 3 is also efficiently converted into fluorescent light.

In the meantime, it is possible to suitably design the shape and size of the concave portion of the LED board 1 in accordance with specifications of the light emitting device 102. For example, a side surface of the concave portion may be tapered. Besides, by forming an inner surface of the concave portion into a reflection surface, a structure may be formed to raise the light emission efficiency of the light emitting device 102.

In addition, the present invention is not limited to each of the embodiments described above, but various modifications are possible within the scope of claims, and embodiments obtained by suitably combining the technical approaches disclosed in the respective different embodiments are also covered by the technical scope of the present invention. Besides, in each of the above embodiments, the light emitting device, which uses both the blue LED and the fluorescer to emit the white light, is described as an example; however, it goes without saying that the present invention is also applicable to a case where a green LED, a red LED and the fluorescer are all used. Further, the fluorescer is not limited to only one kind, but it is possible to use three kinds of fluorescers that absorb ultraviolet light to emit red light, green light, and blue light, respectively, or two kinds of fluorescer, that absorb blue light to emit red light, and green light, respectively. Besides, before applying the first mixed liquid, a light-transmissive ceramic layer like the above ceramic layer 8 may be formed on a surface of the glass substrate 5 or the LED element 3.

Hereinafter, the light emitting device according to the present invention is more specifically described based on embodiment examples and comparative examples. Embodiment examples 1 to 6 are examples of the light emitting device 100 according to the first embodiment, and comparative examples 1, 2 are examples of light emitting devices that have the same shape as the light emitting device 100 according to the first embodiment. In the meantime, embodiment examples of the second and third embodiments are skipped, but the same results as the embodiment examples 1 to 6 are obtained.

### (Preparation example of the fluorescer)

As to the fluorescer used in each embodiment example and comparative example, as fluorescer raw materials, 7.41 g of Y₂O₃, 4.01 g of Gd₂O₃, 0.63 g of CeO₂, and 7.77 g of Al₂O₃ are sufficiently mixed, ammonium fluoride as flux is mixed by a suitable amount and is filled in an aluminum crucible, the crucible is put in a reducing atmosphere in which a hydrogen containing nitrogen gas is flowing and calcined in a temperature range of 1350 to 1450°C for 2 to 5 hours, whereby a calcined product ((Y_{0.72}Gd_{0.24})₃Al₅O₁₂:Ce_{0.04}) is obtained.

The obtained calcined product is broken, washed, separated, and dried, whereby yellow fluorescer particles having an volume average particle diameter of about I µm are obtained. A light emission wavelength under excitation light having a wavelength of 465 nm is measured to find out that the peak wavelength is 570 nm.

G (gram) numbers, that is, weights, used in the following embodiment examples and comparative examples each refer to a mass ratio of each component in a liquid and are different from actually prepared amounts.

### Embodiment example 1

1 g of the fluorescer prepared in the above preparation example, 0.05 g of synthetic mica (the MK-100; Co-op Chemical Co., Ltd.) as the swelling particles, 0.05 g of the RK300 (silylated silicic anhydride whose primary particles have an average particle diameter of 7 nm; Nippon Aerosil Co., Ltd.) as the inorganic particles, 1.5 g of propylene glycol as the solvent are mixed to prepare the first mixed liquid. The first mixed liquid is sprayed onto the concave portion of the LED board 1 and the surface of the LED element 3 by means of the applying device 10 at a spraying pressure of 0.2 MPa, a moving speed of 100 mm/s of the moving table 20, heated and dried at 50°C for 1 hour, whereby the wavelength conversion layer 7 is produced. Next, 1 g of polysiloxane dispersing liquid (14 weight% of polysiloxane, 86 weight% of isopropyl alcohol) and 0.3 g of isopropyl alcohol are mixed to prepare the second mixed liquid. The second mixed liquid is sprayed onto the wavelength conversion layer 7 by means of the applying device 10 to a maximum film thickness where no cracks occur after calcination, heated and calcined at 150°C for 1 hour, whereby the fluorescer of the wavelength conversion layer 7 is fixed and the ceramic layer 8 is produced. Next, phenyl silicone (the KER-6000; Shin-Etsu Chemical Co., Ltd.) is applied onto the ceramic layer 8 by means of the dispenser, heated and hardened at 150°C for 1 hour to produce the silicone sealing layer 11, whereby the light emitting device 100 is obtained. In the meantime, to perform the spraying to obtain the maximum film thickness, the spraying pressure and the moving speed of the moving table 20 are suitably adjusted.

### Embodiment example 2

1 g of the fluorescer prepared in the above preparation example, 0.05 g of smectite (the LUCENT SWN; Co-op Chemical Co., Ltd., hereinafter, called an abbreviation SWN) as the swelling particles, 0.05 g of the RK300 as the inorganic particles, 1.5 g of propylene glycol as the solvent are mixed to prepare the first mixed liquid. The first mixed liquid is used to produce the wavelength conversion layer 7 under the same condition as the embodiment example 1. Next, 1 g of polysiloxane dispersing liquid and 0.3 g of TiO₂ (average particle diameter of 20 nm) slurry dispersing liquid are mixed to prepare the second mixed liquid. The second mixed liquid is used to produce the ceramic layer 8 under the same condition as the embodiment example 1. Next, phenyl silicone is used to produce the silicone sealing layer 11 under the same condition as the embodiment example 1, whereby the light emitting device 100 is obtained.

### Embodiment example 3

1 g of the fluorescer prepared in the above preparation example, 0.05 g of SWN as the swelling particles, 0.05 g of the SYLYSIA 470 (whose primary particles have an average particle diameter of 14 µm, FUJI SILYSIA CHEMICAL LTD.) as the inorganic particles, 1.5 g of propylene glycol as the solvent are mixed to prepare the first mixed liquid. The first mixed liquid is used to produce the wavelength conversion layer 7 under the same condition as the embodiment example 1. Next, I g of polysiloxane dispersing liquid, 0.2 g of zirconia alkoxide (70 weight% of tetrabutoxyzirconium, 30 weight% of 1-butanol), and 0.3 g of ZrO₂ (average particle diameter of 20 nm) slurry dispersing liquid are mixed to prepare the second mixed liquid. The second mixed liquid is used to produce the ceramic layer 8 under the same condition as the embodiment example 1. Next, phenyl silicone is used to produce the silicone sealing layer 11 under the same condition as the embodiment example 1, whereby the light emitting device 100 is obtained.

### Embodiment example 4

1 g of the fluorescer prepared in the above preparation example, 0.05 g of SWN as the swelling particles, 0.05 g of the SYLYSIA 470 as the inorganic particles, and 1.5 g of propylene glycol as the solvent are mixed to prepare the first mixed liquid. The first mixed liquid is used to produce the wavelength conversion layer 7 under the same condition as the embodiment example 1. Next, 1 g of polysiloxane dispersing liquid, 0.2 g of titanium alkoxide (90 weight% of tetrabutyl titanate, 10 weight% of 1-butanol), and 0.3 g of ZrO₂ (average particle diameter of 20 nm) slurry dispersing liquid are mixed to prepare the second mixed liquid. The second mixed liquid is used to produce the ceramic layer 8 under the same condition as the embodiment example 1. Next, phenyl silicone is used to produce the silicone sealing layer 11 under the same condition as the embodiment example 1, whereby the light emitting device 100 is obtained.

### Embodiment example 5

1 g of the fluorescer prepared in the above preparation example, 0.05 g of synthetic mica as the swelling particles, 0.05 g of the RX300 as the inorganic particles, and 1.5 g of propylene glycol as the solvent are mixed to prepare the first mixed liquid. The first mixed liquid is used to produce the wavelength conversion layer 7 under the same condition as the embodiment example 1. Next, 1 g of polysiloxane dispersing liquid, 0.2 g of titanium chelate (40 weight% of titanium lactate, 50 weight% of 2-propanol, and 10 weight% of water), and 0.3 g of TiO₂ (average particle diameter of 20 nm) slurry dispersing liquid are mixed to prepare the second mixed liquid. The second mixed liquid is used to produce the ceramic layer 8 under the same condition as the embodiment example 1. Next, phenyl silicone is used to produce the silicone sealing layer 11 under the same condition as the embodiment example 1, whereby the light emitting device 100 is obtained.

### Embodiment example 6

1 g of the fluorescer prepared in the above preparation example, 0.05 g of SWN as the swelling particles, 0.05 g of the SYLYSIA 470 as the inorganic particles, and 1.5 g of propylene glycol as the solvent are mixed to prepare the first mixed liquid. The first mixed liquid is used to produce the wavelength conversion layer 7 under the same condition as the embodiment example 1. Next, 1 g of polysiloxane dispersing liquid, 0.2 g of zirconia chelate (20 weight% of zirconium tetraacetylacetonate, and 80 weight % of 1-butanol), and 0.3 g of ZrO₂ (average particle diameter of 20 nm) slurry dispersing liquid are mixed to prepare the second mixed liquid. The second mixed liquid is used to produce the ceramic layer 8 under the same condition as the embodiment example 1. Next, phenyl silicone is used to produce the silicone sealing layer 11 under the same condition as the embodiment example 1, whereby the light emitting device 100 is obtained.

### Comparative example 1

9 g of phenyl silicone and 1 g of the fluorescer prepared in the above preparation example are mixed, stirred, applied onto the concave portion of the LED board 1 and the surface of the LED element 3 by means of the dispenser, and heated at 150°C for 1 hour to obtain a light emitting device.

### Comparative example 2

1 g of the fluorescer prepared in the above preparation example, 0.05 g of synthetic mica as the swelling particles, 0.05 g of the RX300 as the inorganic particles, and 1.5 g of propylene glycol as the solvent are mixed to prepare the first mixed liquid. The first mixed liquid is used to produce the wavelength conversion layer under the same condition as the embodiment example 1. Next, 1 g of polysiloxane dispersing liquid, and 0.3 g of isopropyl alcohol are mixed to prepare the second mixed liquid. The second mixed liquid is used to produce the ceramic layer 8 under the same condition as the embodiment example 1, whereby the light emitting device 100 is obtained.

### (Evaluation, study)

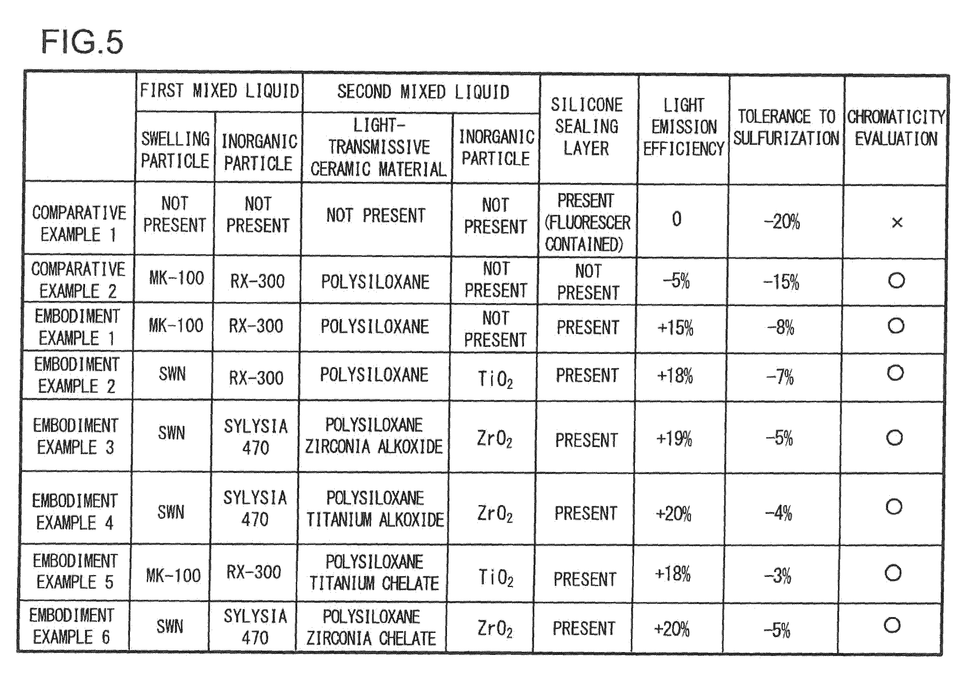

As to the samples of the respective embodiment examples and comparative examples, evaluation of the light emission efficiency, evaluation of the tolerance to sulfurization, and evaluation of the chromaticity are performed. Fig. 5 shows the results. As to the evaluation of the light emission efficiency, all the flux of the light emitting device is measured by means of a spectral radiance meter (the CS-2000, KONICA MINOLTA SENSING, INC.), and relatively compared with all the flux of the comparative example 1 used as a reference.

As to the evaluation of the tolerance to sulfurization, all the flux of the light emitting device is measured before and after a deterioration test, and all the flux of each light emitting device after the deterioration test is relatively compared with all the flux of each light emitting device as a reference before the deterioration test. As to the deterioration test, the light emitting device and sulfur powder are put into a sealed container and left 1 day at 80°C to perform the deterioration test.

The evaluation of the chromaticity is comparison and evaluation of evenness of the chromaticity, in which the light emission chromaticity of each light emitting device is measured by means of a spectral radiance meter (the CS-1000A, KONICA MINOLTA SENSING, INC.) and evaluated as follows. Five samples of each embodiment example and comparative example are prepared and the chromaticity of each sample is measured to obtain standard deviations of the chromaticity. And, an example, whose average of the standard deviations of the chromaticity is larger than 0.01 and equal to or smaller than 0.02, is indicated "ο" as having no practical problem in terms of unevenness of the chromaticity (sufficiently usable in uses such as illumination and the like that require color evenness), and an example, whose average of the standard deviations of the chromaticity is larger than 0.02, is indicated "×" as being impossible for practical use.

The chromaticity is defined by a point where a line, which connects a point and the origin to each other, intersects with a plane x + y + z = I in a CIE-XYZ color display system that represents a color space by means of an XYZ coordinate system; the chromaticity is represented by (x, y) coordinates, and if a z coordinate obtained from the relationship x + y + z = 1 is omitted, the chromaticity of the white light is (0.33, 0.33), and as a chromaticity approaches this value, the light approaches the white light. If an x-coordinate value becomes small, the light becomes bluish white, while if the x-coordinate value becomes large, the light becomes yellowish white.

Studying the evaluation results of the embodiment examples and comparative examples, the comparative example 1 does not have the wavelength conversion layer 7 and ceramic layer 8 according to the above embodiments but only the silicone sealing layer containing the fluorescer is disposed; accordingly, the fluorescer precipitates and the chromaticity has large unevenness. In addition, it cannot be also said that the light output efficiency (light emission efficiency) is very good. Besides, the tolerance to sulfurization is also low.

The comparative example 2 has the wavelength conversion layer 7 and ceramic layer 8 according to the above embodiments; accordingly, the fluorescer disperses evenly and the color unevenness is not a practical problem. However, there is not the silicone sealing layer 11; accordingly, the tolerance to sulfurization is low, and the light emission efficiency is worse than the comparative example 1 that has the silicone sealing layer.

The embodiment examples 1 to 6 have the wavelength conversion layer 7 and ceramic layer 8; accordingly, the fluorescer disperses evenly and the color unevenness is not a practical problem. Further, there is the silicone sealing layer 11; accordingly, the tolerance to sulfurization is high, and the light emission efficiency is also good. Besides, the embodiment examples 1 to 6 indicate that various swelling particles, inorganic particles, and light-transmissive ceramic materials are usable.

As described above, thanks to the wavelength conversion portion 6 according to the above embodiments and embodiment examples, it is possible to reduce the occurrence of the color unevenness to the extent where the light emitting device is sufficiently usable in uses such as illumination and the like that require color evenness and improve the sulfurization preventing performance and the light output efficiency.

### Reference Signs List

- 1: LED board
- 3: LED element (light emitting element)
- 5: glass substrate (light-transmissive substrate)
- 6: wavelength conversion portion
- 7: wavelength conversion layer
- 8: ceramic layer
- 9: wavelength conversion element
- 11: silicone sealing layer
- 40: first mixed liquid
- 100, 101, 102: light emitting devices

## Claims

1. A method for producing a light emitting device comprising:
a step for applying a first mixed liquid, which contains a fluorescer, swelling particles, inorganic particles, and a first solvent, onto a light emitting element,
a step for applying a second mixed liquid, which contains a light-transmissive ceramic material and a second solvent, onto the first mixed liquid and heating the second mixed liquid, and further
a step for applying a silicone sealing material onto the second mixed liquid and heating the silicone sealing material.

2. The method for producing a light emitting device according to claim 1, wherein the second mixed liquid contains water and/or inorganic particles.

3. The method for producing a light emitting device according to claim 1 or 2, wherein the inorganic particles are a metal oxide.

4. The method for producing a light emitting device according to any one of claims 1 to 3, wherein the silicone sealing material is phenyl silicone.

5. A light emitting device produced by a method for producing a light emitting device according to any one of claims 1 to 4.

6. A method for producing a wavelength conversion element comprising:
a step for applying a first mixed liquid, which contains a fluorescer, swelling particles, inorganic particles, and a first solvent, onto at last one surface of a light-transmissive substrate,
a step for applying a second mixed liquid, which contains a light-transmissive ceramic material and a second solvent, onto the first mixed liquid and heating the second mixed liquid, and further
a step for applying a silicone sealing material onto the second mixed liquid and heating the silicone sealing material.

7. The method for producing a wavelength conversion element according to claim 6, wherein the second mixed liquid contains water and/or inorganic particles.

8. The method for producing a wavelength conversion element according to claim 6 or 7, wherein the inorganic particles are a metal oxide.

9. The method for producing a wavelength conversion element according to any one of claims 6 to 8, wherein the silicone sealing material is phenyl silicone.

10. A wavelength conversion element produced by a method for producing a wavelength conversion element according to any one of claims 6 to 9.

11. A method for producing a light emitting device comprising a step for disposing the
wavelength conversion element onto a light emitting side of a light emitting element, the step being added to a method for producing a wavelength conversion element according to any one of claims 6 to 9.

12. A light emitting device produced by the method for producing a light emitting device according to claim 11.
